(19) Europäisches Patentamt
European Patent Office
Office européen des brevets

(11) Veröffentlichungsnummer: **0 071 789**
**B2**

(12) **NEUE EUROPÄISCHE PATENTSCHRIFT**

(45) Veröffentlichungstag der neuen Patentschrift: **08.08.90**

(21) Anmeldenummer: **82106331.0**

(22) Anmeldetag: **15.07.82**

(51) Int. Cl.[5]: **G 03 C 1/72,** G 03 C 1/76, G 03 F 7/027, G 03 F 7/028, G 03 F 7/033

# (54) Für die Herstellung von Photoresistschichten geeignetes Schichtübertragungsmaterial.

(30) Priorität: **07.08.81 DE 3131448**

(43) Veröffentlichungstag der Anmeldung: **16.02.83 Patentblatt 83/07**

(45) Bekanntmachung des Hinweises auf die Patenterteilung: **04.06.86 Patenblatt 86/23**

(45) Bekanntmachung des Hinweises auf die Entscheidung über den Einspruch: **08.08.90 Patentblatt 90/32**

(84) Benannte Vertragsstaaten: **AT BE CH DE FR GB IT LI NL SE**

(56) Entgegenhaltungen:
**EP-A-0 041 640**
**DE-A-3 215 513**
**DE-B-1 200 130**
**DE-B-2 454 676**
**GB-A-2 100 278**
**US-A-2 902 365**
**US-A-3 873 319**

**A.M. Wittfoht, Plastics Technical Dictionary, Part 1, C. Hanser Verlag, München, 1981, Seite 264**

(73) Patentinhaber: **BASF Aktiengesellschaft**
**Carl-Bosch-Strasse 38**
**D-6700 Ludwigshafen (DE)**

(72) Erfinder: **Barzynski, Helmut, Dr.**
**An der Ameisenhalde 49**
**D-6702 Bad Duerkheim (DE)**
Erfinder: **Eckell, Albrecht, Dr.**
**Paul-Klee-Strasse 2**
**D-6710 Frankenthal (DE)**
Erfinder: **Elzer, Albert, Dr.**
**Pappelstrasse 4**
**D-6701 Otterstadt (DE)**
Erfinder: **Klinsmann, Uwe, Dr.**
**Mollstrasse 39**
**D-6800 Mannheim (DE)**
Erfinder: **Leyrer, Reinhold J., Dr.**
**Menzelstrasse 4**
**D-6700 Ludwigshafen (DE)**
Erfinder: **Sanner, Axel, Dr.**
**Lorscher Ring 2C**
**D-6710 Frankenthal (DE)**

**EP 0 071 789 B2**

Courier Press, Leamington Spa, England.

**Beschreibung**

Die Erfindung betrifft photopolymerisierbare Massen mit mindestens einer photopolymerisierbaren, ethylenisch ungesättigten, niedermolekularen Verbindung, einem damit veträglichen polymeren Bindemittel und einem Photopolymerisationsinitiator, die dür Überzugs- und Aufzeichnungsmaterialien, insbesondere die Herstellung von Photolackübertragungsfolien und photopolymeren Resistschichten geeigenet sind und die eine verbesserte Haftung auf metallischen Substratoberflächen aufweisen.

Photopolymerisierbare Aufzeichnungsmassen für die Herstellung von photopolymeren Resistschichten vorzugsweise auf Metalloberflächen, werden im allegemeinen nach den sogenannten Schichtübertragungsverfahren, wie es z.B. in der DE—B 1 522 515 beschrieben ist, verarbeitet. Hierbei wird ein Schichtübertragungsmaterial (auch Trockenfilmresist genannt) aus einem dimensionsstabilen Träger, insbesondere einer Polyesterfolie, und einer daruaf aufgebrachten lichtempfindlichen Schicht aus der photopolymerisierbaren Aufzeichnungsmasse mit der freien Oberfläche der lichtempfindlichen Schicht auf eine Metalloberfläche, insbesondere Kupfer, aufkaschiert, danach die als temporärer Träger dienende Polyesterfolie — entweder vor oder nach der bildmässigen Belichtung der photopolymerisierbaren Schicht — abgezogen und die nicht-belichteten Bereiche der Schicht mit einer geeigneten Entwicklerflüssigkeit ausgewaschen.

Um bei der Weiterverarbeitung der resisttragenden Kupferschichten, insbesondere durch Ätzen der bzw. galvanische Metallabscheidung auf der resistfreien Kupferoberfläche, zu einewandfreien Endprodukten, z.B. gedruckten Schaltungen, zu gelangen, ist es notwendig, dass die resistbildende, photopolymere Schicht eine so grosse Haftung zur Kupferoberfläche besitzt, dass sie durch die Prozesschemiklalien, wie z.B. Entwicklerlösungsmittel, Ätzflüssigkeiten, Galvanisierbäder etc., nicht unterschnitten oder abgelöst wird. Andererseits darf in dem Schichtübertragungsmaterial die Haftung der photopolymerisierbaren Schicht zu der temporären Polyester-Trägerfolie nicht zu gross sein, so dass diese temporäre Trägerfolie nach dem Auflaminieren bzw. Aufkaschieren der photopolymerisierbaren Schicht auf die Kupferoberfläche ohne Schwierigkeiten und Ablösung der photopolymerierbaren Schicht von der Kupferoberfläche abgezogen werden kann.

Es sind bereits eine Reihe von Möglichkeiten beschrieben, die Haftfestigkeit von photopolymeren Resistschichten auf Kupferoberflächen zu verbessern. So sollen beispielsweise gemäss den Lehren der deutschen Offenlegungsschriften 2 063 571, 2 162 207, 2 602 409 und 3 041 223 den photopolymerisierbaren Massen auf Basis von einem polymeren Bindemittel und photopolymerisierbaren Monomeren niedermolekulare heterocyclisce Verbindungen als haftverbessernde Substanzen zugesetzt werden. Bei diesen heterocyclischen Verbindungen handelt es sich insbesondere um spezielle Imidazol- und Triazol-Derivate. Darüberhinaus sind als weitere niedermolekular haftverbessernde Verbindungen beispielsweise organische Carbonsäuren, wie Benzoesäure, Mucochlorsäure und p-Aminobenzoesäure, und Oxidationsmittel, wie Schwefel, Iod, Phosphor oder Peroxidisulfat, bekannt. Nachteilig bei diesen Verbindungen ist, dass durch ihren Zusatz die Lichtempfindlichkeit der photopolymerisierbaren Massen verringert wird. Daher müssen solche niedermolekulare, haftverbessernde Zusätze enthaltenden, photopolymerisierbaren Überzugs- oder Aufzeichnungsmaterialien im allgemeinen für die Praxis zu lang belichtet werden. Weiterhin neigen viele dieser Verbindungen bei längerer Lagerung der photopolymerisierbaren Massen zur Kristallisation, was zur völligen Unbrauchbarkeit der damit hergstellten Aufzeichnungsmassen bzw. Schichtübertragungsmaterialien führt. Um diese Nachteile zu vermeiden, können die niedermolekularen, haftverbessernden Verbindungen nur in geringer Konzentration in den photopolymerisierbaren Massen eingesetzt werden, wodurch andererseits die haftvermittelnde Wirkung begrenzt und die Haftfestigkeit der photopolymeren Resistschichten auf Metalloberflächen häufig nur unzureichend ist.

In der US—A—3 873 319 sowie der DE—A—2 602 410 werden photopolymerisierbare Massen für die Herstellung von Trockenfilmresisten beschrieben, die in Wasser ode wässrigen alkalischen Lösungen entwickelbar sind. Die photopolymerisierbaren Schichten enthalten dabei neben den photopolymerisierbaren Monomeren als polymeres Bindemittel ein carboxylgruppen-haltiges Styrol-Copolymerisat. Die freien Carboxylgruppen in dem Styrol-Copolymerisat verbessern zwar die Haftfestigkeit der Photopolymerschicht auf den metallischen Substratoberflächen, dennoch lässt die Beständigkeit solcher Resistmaterialien gegenüber den in der Praxis eingesetzten Ätzbädern wegen der pH-Empfindlichkeit der eingesetzten polymeren Bindemittel auch im belichteten, d.h. photovernetzten Zustand der Resistschicht vielfach zu wünschen übrig. Darüberhinaus ist die Laerstabilität der auf Kupfer laminierten photopolymerisierbaren Schichten auf Basis von carboxylgruppenhaltigen Styrol-Copolymerisation stark begrenzt.

Weiterhin ist es z.B. aus der DE—A—2 454 676 bekannt, als Bindemittel für photopolymerisierbare Gemische Polyamide, Polyester oder Vinylpolymerisate einzusetzen, die quaternäre Stickstoffatome in solchen Mengen eingebaut enthalten, dass das polymere Bindemittel wasserlöslich ist. Diese Materialien sind, ebenso wie die mit wässrigen Lösungmitteln entwickelbaren, photopolymerisierbaren Gemische auf Basis von carboxylgruppenhaltigen Styrol-Copolymerisaten, für die Herstellung von Photoresistschichten nur bedingt geeignet.

Ausserdem wird in den älteren Anmeldungen DE—A—3 215 513 und GB—A—2 100 278 eine photoempfindliche Harzmasse vorgeschlagen, die neben einer enthylenisch ungesättigten Verbindung und einem Photosensibilisator und/oder Photosensibilisatorsystem ein Copolymerisat eines Monomeren mit

einer aliphatischen Aminogruppe im Molekül und zusätzlich noch die organischen Halogenverbindungen Tetrachlorkohlenstoff, Chloroform, Bromoform, Iodoform, Methylenchlorid, 1,1,1-Trichloethan, Methylenbromid, Methyleniodid, Tetrabromkohlenstoff, 1,1,2,2-Tetrabromethan, Pentabromethan, Tribromacetophenon, Bis-(tribrommethyl)-sulfon, Tribrommethylphenylsulfon, Vinylchlorid und chlorierte Olefine, enthält.

Aufgabe der vorliegenden Erfindung ist es, eine photopolymerisierbare Aufzeichnungsmasse aufzuzeigen, die für die Herstellung von Photoresistschichten und Schichtübertragungsmaterialien geeignet ist und die die Nachteile der bekannten Materialien dieser Art nicht oder nur in erheblich geringerem Umfang aufweist. Insbesondere sollen die photopolymerisierbaren Aufzeichnungsmassen eine verbesserte Haftung auf metallischen Substratoberflächen, insbesondere Kupfer, besitzen, ohne dass durch andere anwendungsstechnische Eingenschaften, wie beispielsweise Lagerfähigkeit oder Belichtungsspielraum, beeinträchtigt werden; die auf den metallischen Substratoberflächen aufgebrachten Resistschichten sollen dabei eine sehr grosse Beständigkeit gegenüber den Prozesschemikalien, insbesondere den bei ihrer Weiterverarbeitung verwendeten Löungsmitteln haben, so dass z.B. ein unkritischeres Arbeiten bezüglich der zulässigen Auswaschzeiten beim Entwicklen der belichteten Resistschicten auch bei Anwendung üblicher Belichtungszeiten möglich ist und die resistbedeckten Metallsubstrate insbesondere auch in aggressiven Ätz- und Galvanisierbädern in vorteilhafter Weise weiterverarbeitet werden können.

Überraschenderweise wurde nun gefunden, dass diese Aufgabe gelöst wird, wenn photopolymerisierbare Aufzeichnungsmassen neben photopolymerisierbaren, ethylenisch ungesättigten, niedermolekularen Verbindungen und Photoinitiatoren als Bindemittel Vinylpolymerisate mit einem geringen Anteil an eingebauten Amino gruppen enthalten.

Gegenstand der Erfindung ist ein Schichtübertragungsmaterial zur Herstellung von Photoresistschichten mit einem vorzugsweise transparenten, temporären dimensionsstabilen Schichtträger, einer darauf befindlichen bei Raumtemperatur festen, trockenen, lichtempfindlichen Schicht sowie einer auf der dem temporären Schichtträger abgewandten Oberfläche der lichtempfindlichen Schicht aufgebrachten Deckfolie, wobei die Haftfestigkeit der Deckfolie zur lichtempfindlichen Schicht geringer ist als die Haftfestigkeit des temporären Schichtträgers zur lichtempfindlichen Schicht und die lichtempfindliche Schicht gebilet wird aus einer für die Herstellung von Photoresistschichten geeigneten, photopolymerisierbaren Aufzeichnungsmasse, welche im wesentlichen besteht aus einer in organischen Lösungsmitteln löslichen oder zumindest dispergierbaren Mischung von

a) einen thermoplastischen Vinylpolymerisat als Bindemittel,

b) mindestens einer mit dem Bindemittel a) verträglichen, photopolymerisierbaren, ethylenisch ungesättigten, niedermolekularen Verbindung,

c) mindestens einem Photopolymerisationsinitiator sowie gegebenenfalls

d) sonstigen üblichen Zusatz- und/oder Hilfsstoffen,

das dadurch gekennzeichnet ist, daß das Bindemittel a) Vinylpolymerisat, welches 0,05 bis bestez aus einem 3 Gew.%, bezogen auf das Vinylpolymerisat, an eingebauten Polymereneinheiten mit Amino-Gruppen enthält, wobei diese Einheiten durch Copolymerisation mit den entsprechenden Monomeren oder durch polymeranaloge Umsetzung in das Vinylpolymerisat eingeführt wurden und wobei das Bindemittel a) zusätzlich bis zu 5 Gew.%, bezogen auf das Bindemittel a), freie Carboxylgruppen enthalten kann, mit der Maßgabe, daß diese freien Carboxylgruppen durch einpolymerisierte Acrylsäure oder Methacrylsäure gebildet sind.

Gegenstand der Erfindung sind weiterhin Verfahren zur Herstellung von Photoresists und spezielle Ausgestaltungsformen der Schichtübertragungsmaterialien gemäss der nachfolgenden detaillierten Beschreibung.

Mit den erfindungsgemäß einzusetzenden photpolymerisierbaren Aufzeichnungsmassen wird eine ausgezeichnete Haftfestigkeit auf metallischen Substratoberflächen, insbesondere Kupfer erzielt, und zwar sowohl im unbelichteten als auch im belichteten Zustand, ohne dass die Haftung zu anderen Stoffen, insbesondere zu den als temporären Träger dienenden Polyesterfolien der Schichtübertragungsmaterialien wesentlich erhöht wird. Im Vergleich zu den photopolymerisierbaren Aufzeichnungsmaterialien, die niedermolekulare, haftverbessernde Zusätze enthalten werden erfindungsgemäss nicht nur die mit diesen niedermolekularen haftverbessernden Zusätzen verbundenen Nachteile vermieden, sondern es werden überraschenderweise eine vergleichsweise erheblich verbesserte Haftfestigkeit auf den metallischen Substraten, eine hohe Bestandigkeit gegenüber den Prozesschemikalien, insbesondere den Galvanisierbädern, und eine hohe Lagerstabilität einer auf Kupfer aufgebrachten Schicht aus der photopolymerisierbaren Aufzeichnungsmasse erzeilt.

Die erfindungsgemäß einzusetzenden photopolymerisierbaren Aufzeichnungsmassen sollen in organischen Lösungsmitteln bzw. organischen Lösungsmittelgemischen löslich oder zumindest dispergierbar sein. Die Schichtübertragungs-materialien enthalten dabei erfindungsgemäss als Bindemittel a) ein thermoplastisches Vinylpolymerisat, wie es durch Polymerisation oder Copolymerisation dur üblichen Vinyl-Monomeren erhalten wird. Vorzugsweise kommen solche thermoplastischen Vinyl-Polymerisate in Betracht, deren Glastemperatur (gemessen nach DIN 52 520) über 40°C liegt. Als Monomere für die Herstellung der Vinylpolymerisate kommen beispielsweise in Betracht; Styrol, α-Methylstyrol, durch Alkyl-, Alkoxy- oder Halogen-Gruppen kernsubstituierte Styrole und α-

Methylstyrole, Vinylchlorid, Vinylidenchlorid, Acrylnitril, Methacrylnitril, Ethylen, Proylen, (Meth)acrylamid, Acrylsäure, Methacrylsäure. Weiterhin kommen insbesondere die Alkylacrylate oder -methacrylate, vorzugsweise mit 1 bis 8 Kohlenstoffatomen im Alkylrest, als Monomere in Betracht. Die Alkylacrylate oder methacrylate können dabei im Alkylrest auch beispielsweise durch Hydroxigruppen oder Aminogruppen substituiert sein. Als Beispiele für solche Acrylate oder Methacrylate seien genannt Methyl(meth)acrylat, Ethyl-(meth)acrylat, Butyl-(meth)acrylat, Hexyl-(meth)acrylat, 2-Ethyl-hexyl-(meth)acrylat, β-Hydroxyethyl-(meth)acrylat, β-Hydroxypropyl-(meth)acrylat, 2-(N,N-Dimethylamino)-ethyl-(meth)acrylat, 2-(N,N-Diethylamino)-ethyl-(meth)acrylat, 3-(N,N-Dimethylamino)-propyl-(meth)acrylat oder 3-(N,N-Diethylamino)-propyl-(meth)acrylat. Gleicherweise kommen auch die entsprechenden N-substituierten (Meth)acrylamide als Monomere in Betracht. Eine weitere Gruppe von sehr geeigneten Monomeren sind die heterocyclischen Vinylverbindungen, wie z.B. N-Vinylimidazol oder 2-Methyl-N-vinylimidazol.

Als besonders geeignet für den erfindungsgemässen Zweck haben sich Styrolpolymerisate sowie insbesondere die Polymerisate und Copolymerisate der genannten Acrylat- bzw. Methacrylat-Monomeren erwiessen. Die Glastemperatur der thermoplastischen Vinylpolymerisate kann durch geeignete Wahl der Monomeren bzw. Comonomeren auf den gewünschten Wert eingestellt werden.

Erfindungsgemäss enthalten die thermoplastischen Vinylpolymerisate Amino-gruppen eingebaut. Die Amino-gruppen können dabei entweder während der Herstellung der Polymerisate durch Mitverwendung von Monomeren mit Amino-gruppen oder aber durch nachträgliche Reaktion der Vinylpolymerisate mit entsprechenden Amino-gruppen enthaltenden Verbindungen in die Vinylpolymerisate eingebracht werden. Als Amino-Gruppen enthaltende Comonomeren sind insbesondere die Acryl- oder Methacrylverbindungen der allgemeinen Formel (I)

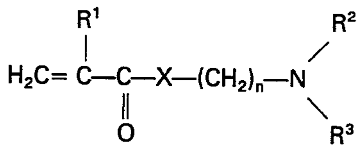

(I)

zu nennen, worin bedeuten

X Sauserstoff-Atom oder eine $NR^4$-Gruppen

$R^1$ ein Wasserstoffatom oder eine Methyl- oder Ethyl-Gruppe

$R^2$, $R^3$ gleiche oder verschiedene Alkyreste mit 1 bis 20 Kohlenstoffatomen, vorzugsweise 1 bis 4 Kohlenstoffatomen, oder $R^2$ und $R^3$ zusammen den Rest eines heterocyclischen Ringsystems mit 4 bis 8, vorzugsweise 5 oder 6 Ringatomen

$H^4$ ein Wasserstoffatom oder ein Alkylrest mit 1 bis 20 vorzugsweise 1 bis 4 Kohlenstoffatomen

n eine ganze Zahl von 1 bis 20.

Beispiele für derartige Acrylate und Methyacrylate sind die weiter oben bereits genannten (N,N-Dialkylamino)-ethyl- bzw. -propyl-(meth)acrylate sowie 2-(N,N-Dimethylamino)-ethyl-acrylamid, 2-(N,N-Dimethylamino)-ethyl-(methy)acrylamid, 3-(N,N-Dimethylamino)-propyl-(meth)acrylamid sowie 3-(N,N-Diethylamino)-propyl-(methy)acrylamid. Als weitere Aminogruppen enthaltenden Comonomere sind beispielsweise die N-heterocyclischen Vinylverbindungen hervorzuheben, wie N-Vinylimidazol oder 2-Methyl-N-vinylimidazol.

Ein nachträglicher Einbau der Amino-gruppen in das Vinylpolymerisat kann z.B. durch Umamidierung bzw. Umesterung der Ester-gruppen von (Meth)acrylat-Polymerisaten erfolgen. Geeignete Verbindungen für eine solche Umamidierung sind z.B. Verbindungen der allgemeinen Formel (II)

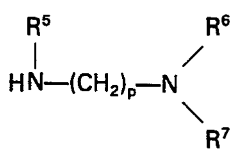

(II)

worin bedeuten

$R^5$ ein Wasserstoffatom oder ein Alkylrest mit 1 bis 20, vorzugsweise 1 bis 2 Kohlenstoffatomen,

$R^6$, $R^7$ gleiche oder verschiedene Alkylrest mit 1 bis 20 Kohlenstoffatomen, vorzugsweise 1 bis 4 Kohlenstoffatomen oder $R^6$ und $R^7$ zusammen ein Heterocyclus mit insgesamt 4 bis 8 und insbesondere 5 oder 6 Ringatomen,

p eine ganze Zahl von 1 bis 20, vorzugsweise 1 bis 4.

Für die Umesterung kommen beispielsweise Verbindungen der allgemeinen Formel (III)

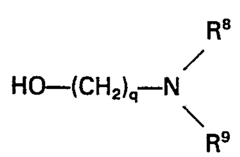

(III)

in Betracht, worin bedeuten

$R^8$, $R^9$ gleiche oder verschiedene Alkylreste mit 1 bis 20 Kolenstoffatomen, vorzugsweise 1 bis 4 Kohlenstoffatomen oder $R^8$ und $R^9$ zusammen ein Heterocyclus mit 4 bis 8 und insbesondere 5 oder 6 Ringatomen,

q eine ganze Zahl von 1 bis 200, vorzugsweise 1 bis 4.

Ausser durch Umamidierung bzw. Umesterung ist es aber auch möglich, Verbindungen des oben genannten Typs der Formeln (II) und (III) durch Reaktion mit einpolymerisierten, reaktionsfähigen Comonomeren, wie z.B. Maleinsäureanhydrid, Acrylsäure oder Glycidylmethacrylat in das als Bindemittel verwendete thermoplastische Vinylpolymerisat einzubringen. Auf welche Art und Weise die Aminogruppen in das thermoplastische Vinylpolymerisat eingeführt werden, ist für deren Einsatz in den erfindungs. Aufzeichnungsmassen nicht von Belang und ist nicht auf die hier beispielhaft aufgezeigten Wege beschränkt. Wichtig ist jedoch, dass der Gehalt an Polymereneinheiten mit Aminogruppen, die in das thermoplastiche Vinylpolymerisat eingebaut sind, im Bereich von 0,05 bis 3 Gew.%, bezogen auf das Vinylpolymerisat, liegt.

Nach einer bevorzugten Ausführungsform der Erfindung ist es auch möglich, dass die Amino-gruppen enthaltenden thermoplastischen Vinylpolymerisate zusätzlich freie Carboxylgruppen eingebaut enthalten. Als Beispiel hierfür seien die Terpolymerisate aus Alkyl-(meth)acrylaten, (Meth)Acrylsäure sowie den oben erwähnten Aminogruppen enthaltenden Alkyl-(meth)acrylaten genannt. Der Gehalt an in das Vinylpolymerisat eingebauten freien Carboxylgruppen kann dabei im allgemeinen im Bereich von 0,1 bis 5 Gew.-%, bezogen auf das gesamte Bindemittel a) liegen. Das Molekulargewicht einer eingebauten freien Carboxylgruppe wird dabei mit 45 gerechnet.

Als Komponente b) der erfindungsgemäß einzusetzenden photopolymerisierbaren Aufzeichnungsmassen kommen die photopolymerisierbaren, ethylenisch ungesättigten, niedermolekularen Verbindungen in Betracht, wie sie für die Herstellung von photopolymerisierbaren Aufzeichnungsmaterialien Überzügen, Druckplatten, Photoresistmaterialien und ähnlichem bekannt und beschrieben sind, soweit sie mit dem als Bindemittel a) eingesetzten thermoplastischen Vinylpolymerisat verträglich sind und einen Siedepunkt bei Atmosphärendruck im allgemeinen von über 100°C besitzen. Bei den photopolymerisierbaren, ethylenisch ungesättig niedermolekularen Verbindungen handelt es sich um ethylenisch ungesättigte Monomere, Oligomere oder Prepolymere mit einem Molekulargewicht im allgemeinen bis etwa 1500, die zur Bildung von Polymeren durch photoinitiierte Polymerisationsrekation fähig sind. Die photopolymerisierbaren, niedermolekularen Verbindungen haben vorzugsweise mindestens eine endständige Vinyl- oder Vinyliden-Doppelbindung. Bevorzugt werden photopolymerisierbare, ethylenisch ungesättigte, niedermolekulare Verbindungen mit 2 oder mehr ethylenisch ungesättigten, photopolymerisierbaren Doppelbindungen eingesetzt. Diese mehrfach ethylenisch ungesättigten, photopolymerisierbaren, niedermolekularen Verbindungen können dabei allein, in Mischung miteiander oder in Mischung mit monofunktionellen niedermolekularen Verbindungen, d.h. mit enfach ungesättigten niedermolekularen Verbindungen eingesetzt werden. In den Mischungen aus polyfunktionellen, photopolymerisierbaren, niedermolekularen Verbindungen und monofunktionellen, photopolymerisierbaren, niedermolekularen Verbindungen kann der Anteil der einzelnen Komponenten in sehr breiten Grenzen variiert werden. Art und Menge der verwendeten Monomeren richten sich weitgehend nach dem Anwendungszweck und nach der Art des verendeten polymeren Bindemittels.

Als Beispiele für die photopolymerisierbaren, ethylenisch ungesättigten, niedermolekularen Verbindungen seien genannt: Allylverbindungen, wie Allylacrylat, Diallylphthalat, Trimellithsäure-di und triallylester oder Ethylenglykolbisallylcarbonat. Besonders günstig sind im allgemeinen Acrylate und Methyacrylate, insbesondere die Di- und Polyacrylate bzw. -methyacrylate, wie sie durch Veresterung von Diolen oder Polyolen mit Acrylsäure oder Methacrylsäure hergestellt werden können, wie z.B. die Di- und Tri-(meth)acrylate von Ethylenglykol, Diethylenglykol, Triethylenglykol, Polyethylenglykol mit einem Molekulargewicht bis etwa 500, 1,2-Propandiol, 1,3-Propandiol, Neopentylglykol(2,2-Dimethylpropandiol), 1,4-Butandiol, 1,1,1-Trimethylolpropan, Glycerin oder Pentaerythrit; ferner die Monoacrylate und Monomethacrylate solcher Diole und Polyole, wie z.B. Ethylenglykolmono-(meth)acrylat, Di-, Tri- oder Tetraethylenglykol-mono-(meth)acrylat, Hydroxypropyl-(meth)acrylat sowie die Acrylate und Methyacrylate von Monoalkoholen, z.B. Laurylacrylat, und insbesondere von Alkanolen mit 1 bis 8 Kohlenstoffatomen, wie beispielsweise Methyl-(meth)acrylat, Ethyl-(meth)acrylat, Propyl-(meth)acrylat, Butyl-(meth)acrylat oder Hexyl-(meth)acrylat. Weiterhin kommen als photopolymerisierbare, ethylenisch ungesattigte, niedermolekulare Verbindungen Derivate der Maleinsäure oder der Fumarsäure im Betracht, sowie neben den Acrylaten und Methacrylaten (Meth)acrylamid bzw. (Meth)acrylamid-Derivate, wie N-Hydroxymethyl-(meth)acrylamid, Xylylen-bis-acrylamid, Alkylen-bis-acrylamide mit 1 bis 8 Kolenstoffatomen im Alkylenrest oder Umsetzungsprodukte von 2 Mol N-Hydroxymethyl-(meth)acrylamid mit einem Mol eines aliphatischen Diols, wie Ethylenglykol. Darüberhinaus eignen sich als photopolymerisierbare, niedermolekulare Verbindungen auch solche, die zusätzlich zu den ethylenischen Doppelbindungen noch Urethangruppen enthalten, wie beispielsweise die Umsetzungsprodukte aus Diolen, insbesondere aliphatischen Diolen oder Polyetherdiolen mit einem Molekulargewicht von 200 bis 500, organischen Diisocyanaten, wie beispielsweise Toluylendiisocyanat, Hexamethylendiisocyanat oder Isophorondiisocyanat, und Hydroxylalkyl-(meth)acrylaten, insbesondere mit 2 bis 4 Kohlenstoffatomen im Alkylrest. Bezüglich weiterer möglicher photopolymerisierbarer, ethylensich ungesättigter, niedermolekularer Verbindungen sei aus die einschlägige Literaur, verwiesen.

Das Mengenverhältnis von Bindemittel a) und photopolymerisierbarer, niedermolekularer Verbindung b) in den erfindungsgemäß einzusetzenden photopolymerisierbaren Aufzeichnungsmassen ist in weiten Umfang variierbar und beträgt im allgemeinen 5 bis 80 Gew.%, vorzugsweise 15 bis 60 Gew.%, an photopolymerisierbaren, ethylenisch ungesättigten, niedermolekularen Verbindungen und 20 bis 95 Gew.%, insbesondere 40 bis 85 Gew.%, an polymerem Bindemittel, jeweils bezogen auf die Summe von polymerem Bindemittel a) und photopolymerisierbarer, niedermolekularer Verbindung b).

Neben dem polymeren Bindemittel a) und den photpolymerisierbaren, niedermolekularen Verbindungen b) enthalten die erfindungsgemäß einzusetzenden photopolymerisierbaren Aufzeichnungsmässen als weitere Komponente c) mindestens einen Photopolymerisationsinitiator. Als Photoinitiatoren kommen dabei grundsätzlich alle Verbindungen in Betracht, die unter der Einwirkung von aktinischem Licht in freie Radikale zerfallen und die radikalische Polymerisation zu initiieren vermögen, wie sie hinreichend bekannt und in der einschlägigen Literatur beschrieben sind. Beispielsweise sei in diesem Zusammenhang verwiesen auf Kosar, Light Sensitive Systems, J. Wiley-Verlag, New York (1965), Seiten 158 bis 193. Besonders vorteilhaft sind die bekannten Carbonylverbindungen, wie aromatische Aldehyde und aromatische Ketone. Hiefür seien als Beispiele genannt: Benzophenon, substituerte Benzophenone, wie Michlers-Keton und Derivate von Michlers-Keton; Benzoin und Derivate des Benzoins, beispielsweise Benzoinether, wie Benzoinisopropylether oder Benzointetrahydropyranylether, α-Methylolbenzoin und α-Methylolbenzoinether, wie α-Methylolbenzoinmethylether; Benzil und Benzilketale, wie z.B. Benzildimethylketal, Benzilmethylethylketal oder Benzilneopentylketal; Anthrachinon und seine Derivate; Thioxanthon und seine Derivate; oder Benzoyldiarylphosphinoxide. Die Photopolymerisationsinitiatoren können allein oder im Mischung miteinander eingesetzt werden; sie können auch zusammen mit bekannten und üblichen Aktivatoren verwendet werden. Vorteilhaft sind beispielsweise insbesondere Kombinationen von Michlers-Keton oder Michlers-Keton-Derivaten mit anderen Photopolymerisationsinitiatoren, beispielsweise Benzophenon. Besonders geeignet sind auch die in der DE—A 2 830 927 und der DE—A 2 909 992 beschriebenen Verbindungen.

Die verwendete Menge an Photopolymerisationsinitiator hängt einerseits von dem Extinktionskoeffizienten des Initiators und andererseits von der Schichtdicke der photopolymerisierbaren Aufzeichnungsmaterilien bei der Härtung ab und beträgt im allgemeinen 0,1 bis 10 Gew.%, insbesondere etwa 0,5 bis 5 Gew.%, bezogen auf die gesamte photopolymerisierbare Aufzeichnungsmasse.

Die photopolymerisierbaren Aufzeichnungsmassen können darüberhinaus weiterhin noch übliche Zusatz- und/oder Hilfsstoffe in den üblichen und bekannten Mengen enthalten. Hierzu gehören unter anderem thermische Polymerisationsinhibitoren, wie z.B. Hydrochinon, tert.-Butylhydrochinon, Chinone, t-Butylcatechin, Pyrogallol, Kupferresinat, β-Naphthol, 2,6-Di-t-butyl-p-kresol, 2,2'Methylen-bis-(4-ethyl-6-t-butylphenol), p-Tolylchinon, N-Nitrosodiphenylamin, Chloranil, Arylphosphite und Arylalkylphosphite. Daneben enthalten die photopolymerisierbaren Aufzeichnungsmassen vorteilhaft sichtbare Kontrast-Farbstoffe und/oder photochrome Veribindungen, die gegenüber den anderen Bestanteilen der Aufzeichnungsmasse inert sind und den Photopolymerisationsprozess nicht stören. Als Beispiele für Kontrastfarbstoffe seien Brilliant Green Dye (C.I. 42 040), Viktoriablau, substituierte Naphthalimidfarbstoffe, Rhodamine, Azosole, Kristallviolett und 3'-Phenyl-7-dimethylamino-2,2'-spirodi-(2H-1-benzopyran) genannt. Zu den photochromen Verbindungen gehören beispielsweise die Leukofarbstoffe, wei Kristallviolett-Leukobase, Malachitgrün-Leukobase, Leuko-Basischblau, Leuko-Pararosanilin, Leuko-Patentblau A oder V. Weitere Hilfsstoffe sind u.a. Weichmacher, wie z.B. Di-2-ethylhexyl-phthalat, Dibutylphthalat, Polynonandiolphthalat mit einem Molekulargewicht von ca. 3000, p- oder o-Toluolsulfonamid, Diisohexyladipat, Triethylenglykoldiacetat, Tricresylphosphat; Verlaufshilfsmittel, wie Silikonöl; Mattierungs- oder Gleitmittel, wie z.B. Wasche etc. Die Zusatz- und/oder Hilfsstoff können in den photopolymerisierbaren Aufzeichnungsmassen in den dür diese Stoffe üblichen und bekannten Mengen vorhanden sein; ihre Menge sollte jedoch im allgemeinen 40 Gew.%, vorzugsweise 15 Gew.%, bezogen auf das photopolymerisierbare Aufzeichnungsmaterial, nicht überschreiten.

Zum Auslösen der Photopolymerisation in den photopolymerisierbaren Aufzeichnungsmassen der Erfindung eignet sich aktinisches Licht einer Wellenlänge von 230 bis 750 nm, insbesondere von 300 bis 420 nm, wobei Emissionsmaxima des aktinischen Lichtes und Absorption des Photoinitiators verteilhafterweise aufeinander abgestimmt sein sollen. Als Strahlungsquellen für aktinisches Licht kommen die für diesen Zweck üblichen und gebräuchlichen Lampen und Leuchtstoffrohren in Betracht, wie beispielsweise Quecksilber-Nieder-, -Mittel- oder -Hockdrucklampen, superaktinische Leuchtstoffröhren, Xenon-Impulslampen, Metalliodid-dotierte Lampen oder Kohlebogenlampen.

Die erfindungsgemässeinzusetzenden photopolymerisierbaren Aufzeichnungsmassen können in an siche bekannter Weise zu UV-härtbaren Überzügen, UV-härtenden Druckfarben und Druckpasten, Photopolymerdruckplatten oder photopolymeren silberfreien photografischen Filmen verarbeitet werden. Wegen ihrer hervorragenden Haftfestigkeit auf metallischen Substrat-Oberflächen, insbesondere Kupfer, eignen sich die erfindungsgemässeinzusetzenden photopolymerisierbaren Aufzeichnungsmassen jedoch ganz besonders für die Herstellung von Photoresistschichten auf metallischen Untergründen, wie Kupfer, Aluminium usw., auf Polymerschichten, anorganischen oder organischen Kristalllen, sowie auf kupferbelegten Platten aus Harz, glasfaserverstärkten Kunststoffen, Papier oder auf Glas, wie sie beispielsweise für die Herstellung von gedruckten Schaltungen, integrierten Schaltkreisen, beschrifteten Schildern oder bildmässig geätzter Ware Verwendung finden.

In den lichtempfindlichen Aufzeichnungsmassen liegen die Komponenten in inniger Mischung miteinander vor, wobei das Mischen der Komponenten in an sich bekannter und üblicher Weise, beispielsweise mechanisch oder in Lösung erfolgen kann. Zur Herstellung von Photoresistschichten wird die photopolymerisierbare Aufzeichnungsmasse in geeigneter Weise auf die metallische Substratoberfläche, insbesondere die Kupferoberfläche, beispielsweise einer mit Kuppfer überzogenen Epoxidharztafel, aufgebracht. Dieses kann durch Auftrag einer Lösung der die photopolymerisierbare Aufzeichnungsmasse bildenden Komponenten auf die metallische Substratoberfläche, beispielsweise durch Giessen, Sprühen oder Tauchen, und anschliessendes Verdampfen des Lösungsmittels und Trocknen der photopolymerisierbaren Resistschicht geschehen. Die Lösung wird dabei derart aufgebracht, dass die Trockenschichtstärke der photopolymerisierbaren Photoresistschicht nach dem Abdampfen des Lösungsmittels im allgemeinen im Bereich von 1 bis 200 µm, insbesondere von 10 bis 100 µm liegt. Als Lösungsmittel kommen hierbeije nach Art des verwendeten polymeren Bindemittels a) — die üblichen Alkohole, Ester, Ketone, Ether, halogenierten aliphatischen Kohlenwasserstoffe oder aromatsichen Lösungsmittel, wässerigen Lösungen sowie entsprechende Lösungsmittelgemische in Betracht.

Vorteilhafterweise werden die Photoresistschichten nach dem Schictübertragungsverfahren auf die metallische SUbstratoberfläche, insbesondere Kupfer, aufgebracht. Wegen der ausgezeichneten Haftfestigkeit zu den metallischen Substratoberflächen und insbesondere Kupfer sowie wegen ihrer sehr deutlich aubgestuften Haftfestigkeit geneüber anderen Materialien, die in den Schichtübertragungsmaterialien im allgemeinen als temporärer Schichtträger eingesetzt werden, eignen sich die erfindungsgemässeinzusetzenden photopolymerisierbaren Aufzeichnungsmassen in hervorragender Weise für das Schichtübertragungsverfahren, wie es beispielsweise in der DE—B 1 522 515 beschrieben ist. Für die Herstellung von Schichtübertragungsmaterialien werden solche photopolymerisierbaren Aufzeichnungsmassen gewählt, die bei Raumtemperatur fest, trocken und vorzugsweise nicht klebrig sind, die sich aber im schichtförmigen Zustand in an sich bekannter Weise unter Druck und gegebenenfalls unter gleichzeitigem Eerwärmen auf Temperaturen bis zu 160°C auf die Kupferoberfläche laminieren bzw. kaschieren lassen.

Die Schichtübertragungsmaterialien haben den an sich bekannten Aufbau und bestehen im wesentlichen aus einem temporären Schichtträger, einer lichtempfindlichen resistbildenden Schicht aus der photopolymerisierbaren Aufzeichnungsmasse sowie gegebenenfalls einer Deckfolie zum Schutz der dem temporären Schichtträger abgewandten Seite der lichtempfindlichen Schicht. Als Schichtträger kommen an sich beliebige blatt- bzw. bahnförmige, biegsame Materialien mit hinreichender Dimensionsstabilität in Betracht. Besonders bewährt haben sich hierfür Kunststoffoberlien, insbesondere Polyesterfolien, beispielsweise aus Polyethylenterephthalat und/oder Polybutylenterephthalat. Der temporäre Schichtträger hat im allgemeinen eine Dicke von 3 bis 250 µm, insbesondere von 8 bis 50 µm. Der temporäre Schichtträger kann transparent, d.h. für aktinisches Licht durchlässig sein; da wegen der guten und abgestuften Hafteigenschaften der erfindungsmässeinzusetzenden photopolymerisierbaren Aufzeichnungsmassen der temporäre Schichtträger nach der Schichtübertragung ohne Schwierigkeiten und ohne Beschädigung der lichtempfindlichen Resistschicht von dieser bereits vor der Belichtung abgezogen werden kann, ist es auch möglich, opake, nicht transparente temporäre Schichtträger, wie beispielsweise pigementierte Kunststoffolien zu verwenden. Letzteres bringt insbesondere grosse Vorteile bei der Lagerung und Handhabung der Schichtübertragungsmaterialien, insbesondere wenn gleichzeitig eine für aktinisches Licht nicht durchlässige Deckfolie auf der anderen Seite der lichtempfindlichen Schicht aufgebracht ist.

Die Deckfolie der Schichtübertragungsmaterialien dient in erster Linie dem Schutz der lichtempfindlichen Schicht und braucht daher nicht unbedingt dimensionsstabil zu sein, sie muss sich jedoch leichter von der lichtempfindlichen Schicht abziehen lassen als der temporäre Schichtträger. Als Deckfolienmaterial sind beispielsweise Polyethylen- oder Polypropylenfolien oder Silikonpapier geeignet. Die Stärke der Deckfolien liegt im allgemeinen zwischen 5 und 200 µm.

Die erfindungsgemässen Schichtübertragungsmaterialien werden hergestellt, indem man auf den temporären Schichtträger eine Schicht aus der oben beschriebenen photopolymerisierbaren Aufzeichnungsmasse aufbringt und dann auf die freie Oberfläche dieser Schicht die Deckfolie durch Aufpressen oder Auflaminieren aufbringt, beispielsweise indem man die Deckfolie und da beschichtete lichtvernetzbare Material durch Walzen lauften lässt. Das Aufbringen der lichtempfindlichen Schicht aus der photopolymerisierbaren Aufzeichnungsmasse auf den temporären Schichtträger kann nach den üblichen und beknnten Methoden, beispielsweise durch Giessen von Lösungen der photopolymerisierbaren Aufzeichnungsmasse, wie es oben für die Herstellung der Photoresistschichten bereits erwähnt worden ist, erfolgen. Es ist aber auch möglich, zunächst aus der photopolymerisierbaren Aufzeichnungsmasse beispielsweise durch Pressen oder Extrudieren, eine Schicht vorzuformen und diese dann auf den temporären Schichtträger, gegebenenfalls gleichzeitig mit der Deckfolie, aufzukaschieren oder aufzulaminieren. Die Dicke der lichtempfindlichen Schicht der Schichtübertragungsmaterialien liegt in der Regel im Bereich von 1 bis 200 µm, vorzugsweise im Bereich von 10 bis 100 µm.

Die Anwendung der Schichtübertragungsmaterialien sowie die Herstellung von Photoresists mittels dieser Schichtübertragungsmaterialien ist an sich bekannte und beschrieben, so dass wegen näherer Einzelheiten diesbezüglich auf die einschlägige Literatur verwiesen wird. Die Schichtübertragung erfolgt, indem man zunächst eine gegebenenfalls vorhandene Deckfolie abzieht und die freie Oberfläche der

lichtempfindlichen Schicht unter Druck und gegebenenfalls Erwärmen auf die metallische Substratoberflache kaschiert. Direkt nach dem Kaschieren auf die metallische Substratoberfläche kann bei den erfindungsgemässen Schichtübertragungsmaterialien das Abziehen des temporären Schichtträgers erfolgen; anschliessend wird die Photoresistschicht durch eine Vorlage bildmässig belichtet. Bei Einsatz von transparenten temporären Schichtträgern ist es auch möglich, zunächst durch den temporären Schichtträger hindurch zu belichten und diesen erst anschliessend aubzusiehen. Die bildmässig belichtete Photoresistschicht wird danach in geeigneter Weise unter Entfernung der unbelichteten Schichtanteile entwickelt. Dies kann insbesondere durch Behandeln mit einem geeigneten Lösungsmittel oder Lösungsmittelgemisch in bekannter und üblicher Weise geschehen. Die Wahl des Entwicklerlösungsmittels richtet sich in erster Linie nach dem als Bindemittel a) verwendeten Vinylpolymerisat. Als Entwicklerflüssigkeiten kommen die bereits weiter oben erwähnten Alkohole, Ester, Ketone, Ether, halogenierten aliphatischen Kohlenwasserstoffe sowie flüssigen aromatischen Kohlenwasserstoffe allein oder im Gemisch miteinander oder auch entsprechende wässrige Lösungen in Betracht.

Die freigelegten Stellen der metallischen Substratöberflache können dann in üblicher Weise beispielsweise durch Ätzung oder galvanische Metallabscheidung weiterbehandelt werden, wobei die hohe Beständigkeit der mit den erfindungsgemäß einzusetzenden Aufzeichnungsmassen hergestellten Photoresists gegenüber den in der Praxis verwendeten Galvanisierbädern hervorzuheben ist.

Die Erfindung wird durch die nachfolgenden Beispiele erläutert. Die in den Beispielen und Vergleichsversuchen genannten Teile und Prozente beziehen sich, soweit nicht anders angegeben, auf das Gewicht.

Beispiel 1

Unter Rühren wurde folgende Lösung mit einem Feststoffgehalt von etwa 25% in Essigester hergestellt:

| | |
|---|---|
| Copolymerisat aus 97% Methylmethacrylat und 3% N,N-Dimethylaminoethyl-methacrylat mit einem Molekulargewicht von etwa 180 000 | 53 % |
| Trimethylolpropan-triacrylat | 33,8 % |
| 4,4'-Bis-(dimethylamino)benzophenon | 0,28 % |
| Benzophenon | 3,0 % |
| N-Nitrosodiphenylamin | 0,012 % |
| Kristallviolett | 0,008 % |
| Kristallviolett-Leukobase | 0,6 % |
| Silikonöl | 0,1 % |
| 2,5-Dichlor-1,4-bis(dichlormethyl)-benzol | 2,0 % |
| p-Toluolsulfonamid | 7,2 % |

Die Lösung wurde durch eine Druckfilter mit 1 µm Porendurchmesser filtriert und auf eine 23 µm dicke Polyesterfolie in solcher Menge schichtförmig gegossen, dass nach dem Trocknen unter Warmluft eine lichtempfindliche Schicht von 48 µm Dicke verblieb. Der Trockenfilmresist wurden mit einer 30 µm dicken Folie aus Niederdruckpolyethylen bedeckt. Das dreischichtige Material wurde auf auf eine Breite von 50 cm geschnitten, auf einen Pappkern aufgewickelt und als Rolle im Dunkeln gelagert. Vor der Verwendung als trokken-laminierbarer Photolack wurde die Polyethylendeckfolie in einem handelsüblichen Laminierautomat abgteschält und die lichtempfindliche, resistbildende Schicit auf vorgebürstete, kupferplattinierte Epoxidharz-Glasfaserplattern bei 110°C mit einer Geschwindigkeit von 1 m/min aufkaschiert. Die Platten wurden in Streifen von 2 cm Breite geschnitten. An diesen Streifen wurde die Haftung zwischen den einzelnen Schichten mit einem Instron 1026-Gerät unter Messung der für das Abziehen der einzelnen Schichten notwendigen Kraft bestimmt. Die Haftung zwischen lichtempfindlicher, photoresistbildender Schicht und temporärem Polyester-Träger betrug 156 p/2 cm; die Haftung zwischen lichtempfindlicher, photoresistbildender Schicht und Kupferoberfläche betrug 784 p/2 cm.

Beispiel 2

Es wurde eine Lösung wie in Beispiel 1 hergestellt, jedoch wurde diesmal das dort verwendete Methylmethacrylat-Copolymerisat durch ein Methylmethacrylat/Acrylsäure/N,N-Dimethylaminoethylacrylat-Terpolymerisat mit einem Molekulargewicht von ca. 140 000 ersetzt, wobei das Terpolymerisat 0,08% Acrylsäure und 0,05% Diethylaminoethylacrylat (Rest Methylmethacrylat) einpolymerisiert enthielt. Die nach Beispiel 1 hergestellten Platten zeigten Haftwerte zwischen Polyester-Trägerfolie und photopolymerisierbarer, photoresistbildender Schicht von 95 p/2 cm und zwischen Kupfer und photopolymerisierbarer, photoresistbildender Schicht von 810 p/2 cm.

Vergleichsversuch A

Es wurde eine Lösung wie in Beispiel 1 hergestellt, nur dass diesmal anstelle des dort verwendeten Methylmethacrylat-Copolymerisats ein Polymerisat-Gemisch aus 40 Teilen eines Polymethylmethacrylats mit einem Molekulargewicht von etwa 350 000 und 60 Teilen eines Polymethylmethacrylats mit einem Molekulargewicht von 30 000 eingesetzt wurde. Bei der wie in Beispiel 1 durchgeführten Haftprüfung ergab sich zwischen Polyester-Träger und photopolymerisierbarer, resistbildender Schicht ein Haftwert von 135 p/2 cm, zwischen photopolymerisierbarer, resistbildender Schicht und Kupfer ein Haftwert von 117 p/2 cm.

Vergleichsversuch B

Es wurde eine Lösung wie in Vergleichsversuch A hergestellt. Zusätzlich wurden in die Lösung 0,3% Benzotriazol als niedermolekularer Haftvermittler zugegeben. Nach der Herstellung der 2 cm breiten Streifen wurde wie in Beispiel 1 die Haftung gemessen. Es ergab sich zwischen photopolymerisierbarer, resistbildender Schicht und Polyester-Trägerfolie ein Wert von 139 p/2 cm und zwischen photopolymerisierbarer, resistbildender Schicht und Kupfer ein Wert von 227 pm/2 cm.

Vergleichsversuch C

Wird wie in Vergleichversuch B gearbeitet, das Benzotriazol jedock durch 3% an Triphenylphosphin als niedermolekularer Haftvermittler ersetz, beträgt die Haftung zwischen photopolymerisierbarer, resistbildender Schicht und Polyester-Trägerfolie 151 p/2 cm und zwischen photopolymerisierbarer, resistbildender Schicht und Kupfer 197 p/2 cm.

Vergleichsversuch D

Es wurde wie in Vergleichsversuch B gearbeitet, das Benzotriazol jedoch durch 0,3% p-Aminobenzoesäure ersetzt. Bei der Prüfung wurden für die Haftung zwischen photopolymerisierbarer, resistbildender Schicht und Polyester-Trägerfolie ein Wert von 134 p/2 cm, zwischen photopolymerisierbarer, resistbildender Schicht und Kupfer ein Wert von 213 pm/2 vm gemessen.

Beispiel 3

Es wurde eine Lösung wie in Beispiel 1 hergestellt und der damit gebossenen Film wurde wie dort angegeben auf eine kupferplattierte Platte aufkaschiert. Diese Platte wurde mit UV-Licht durch eine photografische Negativvorlage eines elektrischen Schaltbildes 0,1 min lang belichtet. Danach waren die belichteten Schichtteile von blauviolett nach dunkelblau-violett verfärbt und ergaben einen ausgezeichneten Kontrast. Die Polyester-Trägerfolie wurde abgezogen und die unbelichteten Schichtanteile wurden mit 1,1,1-Trichlorethan ausgewaschen.

Mit dem so erhaltenen Resist wurde der sogenannte Tape-Test durchgeführt. Hierzu wurde die noch vorhandene Resistschicht mit einem Tesafilm überklebt. Beim anschliessenden raschen Abziehen des Tesafilms blieben keine Resistanteile an dem Tesafilm kleben, d.h. dass auch nach der Belichtung und Entwicklung das Photoresistmaterial auf dem Kupfer unbeeinflusst haftet.

Beispiele 4 und 5

Der in Beispiel 4 durchgeführte Tape-Test wurde mit der Lösung aus Beispiel 2 wiederholt. Es wurden die gleichen Ergebnisse wie in Beispiel 3 erzeilt.

Vergleichsversuche E

Beispiel 3 wurde wiederholt, jedoch wurde diesmal zur Herstellung des Resists die Lösung von Vergleichsversuch A verwendet. Nach der bildmässigen Belichtung und dem Entwicklen der lichtempfindlichen Schicht war die Haftung zwischen noch vorhandener Photoresistschicht und Kupfer auf ein Minimum gesunken. Bei dem Tape-Test blieb der nicht-ausgewaschene Photoresist zu fast 100% auf dem Tesafilm kleben.

Vergleichsversuche F, G und H

Vergleichsversuch E wurde jeweils mit den Lösungen aus den Vergleichsversuchen B, C und D wiederholt. Es wurde hierfür wie in Beispiel 4 eine Schicht gegossen, auf eine kupferplattierte Platte kaschiert und anschliessend belichtet und ausgewaschen und mit einem Tesafilm überklebt. Beim Abziehen des Tesafilms blieben 30 bis 50% des Photoresists auf dem Tesafilm kleben. Insbesondere die feinen Linien wurden durch den Tesafilm von Kupfer abgezogen.

Beispiel 6

Es wurde eine Lösung wie in Beispiel 1 hergestellt und der damit gegossende Film wie dort angegeben auf einer kupferplattierten Platte aufkaschiert. Danach wurde diese Platte mit UV-Licht durch eine Positivvorlage eines elektrischen Schaltbildes 0,1 min belichtet. Die Polyesterfolie wurde abgezogen, die unbelichteten Schichtbestandteile ausgewaschen und auf die freigelegte Kupferoberfläche galvanisch

0,045 mm Glanzzinn aufgetragen. Wird anschliessend ein Tesafilm aufgeklebt und rasch abgezogen, so wurden die zwischen den Zinnbahnen vorhandenen Resistbestandteile nicht abgezogen.

Beisipiele 7 und 8

Es wurde wie in Beispiel 6 verfharen, nur wurden hierbei zur Herstellung der photopolymerisierbaren Schicht die Lösungen aus Beispiel 2 eingesetzt. Der Tape-Test nach der galvanischen Zinnscheidung lieferte die gleichen Ergebenisse wie in Beispiel 6.

Vergleichsversuch I

Wird wie in Beispiel 6 gearbeitet, jedoch zur Herstellung der photopolymerisierbaren Schicht eine Lösung wie in Vergleichsversuch A eingesetzt, so wird nach der Zinnabscheidung durch einen auf die Platte aufgeklebten Tesafilm das zwischen den Zinnbahnen vorhandene Resistmaterial zu fast 100% abgezogen.

Vergleichsversuche K, L und M

Vergleichsversuch I wurde wiederholt, diesmal jedoch mit den Lösungen aus den Vergleichsversuchen B, C und D. Nach der galvanischen Zinnabscheidung wurde auf die Platten ein Tesafilm aufgeklebt und rasch abgezogen. Dabei wurde das zwischen den Zinnbahnen vorhandene Resistmaterial zu 40 bis 60% abgezogen.

Beispiel 9

Es wurde eine Lösung wie in Beispiel 1 hergestellt und daraus auf eine Polyester-Trägerfolie ein Film gegossen. Dieser Film wurde auf eine kupferbeschichtete Platte auskaschiert und wie in Beispiel 6 mit UV-Licht duch eine Positivvorlage eines elektrischen Schaltbildes 0,1 min belichtet und nach Abziehen der Polyesterfolie mit 1,1,1-Trichlorethan entwickelt. Auf der freigelegten Kupferoberfläche wurden galvanisch nacheinander 0,035 mm Kupfer, 0,005 mm Nickel und 0,002 mm Gold abgeschieden. Durch Spülen mit Methylenchlorid wurde das restliche, immer noch fehlerfrei haftende Resistmaterial abgewaschen und das freistehende Kupfer mit einer ammoniakalischen Kupfernitrat-Lösung geätzt. Man erheilt eine Leiterplatte, die eine ausgezeichnete Kantenschärfe der Lieterbahnen aufwies.

Beispiel 10

Eine gebürstete Messingfolie von 0,1 mm Schichtdicke wurde beidseitig mit dem Film-Resist aus Beispiel 1 bei 120°C laminiert und anschliessend bildmässig durch zwei passgerechte Negative belichtet. Nach Auswaschen der unbelichteten Schichtanteile mit Methylchloroform und anschliessendes Wegätzen der freigelegten Metallpartien in Salpetersäure wurde ein Formätzteil mit einer ausgezeichnet ausgeprägten Kantenschärfe und Reproduktionsgenauigkeit erhalten.

Beispiel 11

Eine Stahlplatte wurde einseitig mit dem Filmresist aus Beispiel 1 bei 120°C laminiert, bildmässig durch ein Prüfnegativ belichtet und in Methylchloroform entwickelt.

Durch einseitiges Besprühen mit halbkonzentrierter Salpetersäure konnten die freigelegten Teile der Stahlplatte bis auf 1 mm geätzt werden, ohne dass vom Filmresist bedeckte Teile der Stahlplatte unterätzt wurden.

Beispiel 12

Es wurde eine Lösung wie Beispiel 1 hergestellt, nur dass staff des Trimethylolpropan-triacrylates eine Mischung aus 90% eines Monomeren mit einem Molekulargewicht von ca. 1000, erhalten durch Umsetzung von Polyoxibutylen und Butandiolmonoacrylat mit Toluylendiisocyanat, und 10% Tetraethylenglykoldimethacrylat eingesetz wurde. Weiterhin wurden diesmal insgesamt 60,2% des copolymeren Bindemittels verwendet und dafür auf den Zusatz von p-Toluolusulfonamid verzichtet. Die damit wie in Beispiel 1 auf eine Polyesterfolie gegossene Schicht wurde unter Warmluft getrocknet. Das Schichtübertragungsmaterial konnte ohne zusätzliche Deckfolie auf einen Pappkern aufgewickelt und gelagert werden.

Bei Verwendung als trocken-laminierbarer Photolack wurde unmittelbar nach dem Laminieren auf eine kupferplattierte Expoxidharz-Glasfaserplatte bei 140°C mit einer Geschwindigkeit von 0,7 m/min die Polyesterträgerfolie abgezogen. Danach wurde die auf Kupfer hervorragend haftende lichtempfindliche, photoresistbildende Schicht durch eine Photomaske belichtet und mit 1,1,1-Trichlorethan ausgewaschen. 30 µm breite Linien, die im Abstand von 30 µm aufeinander folgen, wurden sauber aufgelöst und konnten wie in den Beispielen 6 und 9 weiterverarbeitet werden.

**Patentansprüche**

1. Schichtübertragsungsmaterial zur Herstellung von Photoresistschichten mit einem temporären dimensionsstabilen Schichtträger, einer darauf befindlichen bei Raumtemperatur festen, trockenen, lichtempfindlichen Schicht sowie einer auf der dem temporären Schichtträger abgewandten Oberfläche der lichtempfindlichen Schicht aufgebrachten Deckfolie, wobei die Haftfestigkeit der Deckfolie zur lichtempfindlichen Schicht geringer ist als die Haftfestigkeit des temporären Schichtträgers zur lichtempfindlichen Schicht und die lichtempfindliche Schicht gebildet wird aus einer für die Herstellung von Photoresistschichten geeigneten, photopolymerisierbaren Aufzeichnungsmasse, welche im wesentlichen besteht aus einer in organischen Lösungsmitteln löslichen oder zumindest dispergierbaren Mischung von

a) einem thermoplastischen Vinylpolymerisat als Bindemittel,

b) mindestens einer mit dem Bindemittel a) verträglichen, photopolymerisierbaren, ethylenisch ungesättigten niedermolekularen Verbindung,

c) mindestens einem Photopolymerisationsinitiator sowie gegebenenfalls

d) sonstigen überlichen Zusatz- und/oder Hilfsstoffen

dadurch gekennzeichnet, daß das Bindemittel a) besteht aus einem Vinylpolymerisat, welches 0,05 bis 3 Gew.-%, bezogen auf das Vinylpolymerisat, an eingebauten Polymereneinheiten mit Amino-Gruppen enthält, wobei diese Einheiten durch Copolymerisation mit den entsprechenden Monomeren oder durch polymeranalogue Umsetzung in das Vinylpolymerisat eingeführt werden und wobei das Bindemittel a) zusätzlich bis zu 5 Gew.%, bezogen auf das Bindemittel, a), freie Carboxylgruppen enthalten kann, mit der Maßgabe, daß diese freien Carboxylgruppen durch einpolymerisierte Acrylsäure oder Methacrylsäure geildet sind.

2. Schichtübertragungsmaterial nach Anspruch 1, dadurch gekennzeichnet, daß es sich bei dem Amino-Gruppen enthaltenden Vinylpolymerisat um ein Acrylat- oder Methacrylat-Polymerisat handelt.

3. Schichtübertragungsmaterial nach einem der Ansprüche 1 bis 2, dadurch gekennzeichnet, daß die lichtempfindliche Schicht als Bindemittelkomponente a) ein Copolymerisat von Vinylmonomeren, insbesondere Acrylaten und/oder Methacrylaten, mit Comonomeren der Formel 1

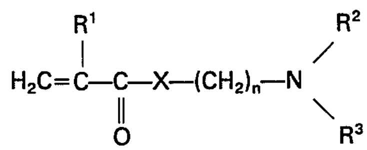

(I)

enthält, worin bedeuten

X Sauerstoff-Atom oder $NR^4$,

$R^1$ ein Wasserstoffatom, eine Methyl- oder Ethyl-Gruppe,

$R^2$, $R^3$ gleiche oder verschiedene Alkylreste mit 1 bis 20 Kohlenstoffatomen oder $R^2$ und $R^3$ zusammen den Rest eines heterocyclischen Ringsystems mit 4 bis 8 Ringatomen,

$R^4$ ein Wasserstoffatom oder ein Alkylrest mit 1 bis 20 Kohlenstoffatomen,

n eine Zahl von 1 bis 20.

4. Schichtübertragungsmaterial nach einem der Ansprüche 1 bis 2, dadurch gekennzeichnet, daß die lichtempfindliche Schicht als Bindemittelkomponente a) ein Amino-Gruppen enthaltendes Vinylpolymerisat enthält, welches hergestellt worden ist durch Umsetzung eines reaktive Gruppen enthaltenden Vinylpolymeren mit Verbindungen der allgemeinen Formel II) oder (III)

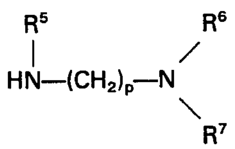

(II)

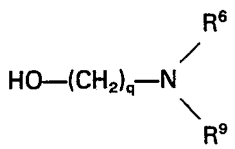

(III)

wobei bedeuten

$R^5$ ein Wasserstoffatom oder ein Alkylrest mit 1 bis 20 Kohlenstoffatomen,

$R^6$, $R^7$, $R^8$, $R^9$ jeweils gleiche oder verschiedene Alkylreste mit 1 bis 20 Kohlenstoffatomen, wobei die Reste $R^6$ und $R^7$ bzw. $R^8$ und $R^9$ jeweils unter Bildung eines heterocyclischen Ringsystems mit 4 bis 8 Ringatomen miteinander verknüpft sein können,

p, q jeweils eine ganze Zahl von 1 bis 20.

5. Schichtübertragungsmaterial nach einem der Ansprüche 1 bis 4, dadurch gekennzeichnet, daß das Amino-Gruppen enthaltende Vinlypolymerisat zusätzlich freie Säuregruppen, insbesondere —COOH-Gruppen, in einer Menge von 0,1 bis 5 Gew.-%, bezogen auf das gesamte Bindemittel a), eingebaut enthält.

6. Schichtübertragungsmaterial nach einem der Ansprüche 1 bis 5, dadurch gekennzeichnet, daß die lichtempfindliche Schicht mindestens einen Farbstoff enthält.

7. Schichtübertragungsmaterial nach einem der Ansprüche 1 bis 5, dadurch gekennzeichnet, daß die lichtempfindliche Schicht mindestens eine photochrome Verbindung enthält.

8. Verfahren zur Herstellung von Photoresists auf metallischen Untergründen mittels eines Schichtübertragungsmaterial mit einer auf einem dimensionsstabilen, temporären Schichtträger aufgebrachten lichtempfindlichen Schicht sowie einer Deckfolie auf der lichtempfindlichen Schicht, durch Azsiehen der Deckfolie von der lichtempfindlichen Schicht, Auflaminieren der lichtempfindlichen Schicht unter Druck sowie gegebenenfalls Wärme auf den metallischen Untergrund, bildmäßiges Belichten der

lichtempfindlichen Schicht, wobei der temporäre Schichtträger wahlweise vor oder nach der bildmäßigen Belichtung von der lichtempfindlichen Schicht abgezogen wird, und schließlich Auswaschen der unbelichteten Bereiche der lichtempfindlichen Schicht mit einem geeigneten Lösungsmittel, dadurch gekennzeichnet, daß in diesem Verfahren ein Schichtübertragungsmaterial nach einem der Ansprüche 1 bis eingesetzt wird.

**Revendications**

1. Matériau de transfert stratifié pour la fabrication de couches de photoréserve (photoresist); comprenant un support de couche, stable en dimension, temporaire, une couche sensible à la lumière, sèche, solide à la température ordinaire, disposée sur la précédente, ainsi qu'une feuille de dessus appliquée sur la surface de la couche sensible à la lumière écartée du support de couche temporaire, la force a'dhérence de la feuille de dessus à la couche sensible à la lumière étant plus faible que la force d'adhérence du support de couche temporaire à la couche sensible à la lumière et la couche sensible à la lumière étant formée d'une masse d'enregistrement appropriée pour la fabrication de couches de photoréserve et qui est constitutée essentiellement d'un mélange, soluble ou au moins dispersable dans un solvant organique, de

a) un polymérisat vinylique thermoplastique comme liant

b) au moins un composé à bas poids moléculaire insaturé éthyléniquement, photopolymérisable, compatible avec le liant (a)

c) au moins un initiateur de photopolymérisation ainsi qu'éventuellement

d) d'autres additifs et/ou auxilaires usuels

caractérisé par le fait que le liant (a) est constitué d'un polymérisat vinylique qui contient 0,05 à 3% en poids, rapportés au polymérisat vinylique, de motifs polyméres incorporés, à groupes amino, ces motifs ayant été introduits par copolymérisation avec les monomères correspondants ou par réaction analogue de polymère dans le polymérisat vinylique et le liant a) pouvant contenir additionnellement jusqu'à 5% en poids, rapportés au liant a), de groupes carboxyle libres, sous condition que ces groupes carboxyle libres soient formés par de l'acide acrylique ou de l'acide méthacrylique entrés en polymérisation.

2. Matériau de transfert stratifié selon la revendication 1, caractérisé par le fait s'agit, pour le polymérisat vinylique contenant des groupes amino, d'un polymérisat d'acrylate ou de méthyacrylate.

3. Matériau de transfert stratifié selon l'une des revendications 1 et 2, caractérisé par le fait que la couche sensible à la lumière contient, comme composant de liant a), un copolymérisat de monomères vinyliques, en particulier acrylates et/ou méthacrylates, avec des comonomères de formule I

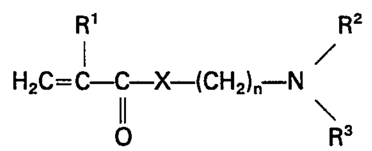 (I)

où

X représente un atome d'oxygène ou $NR^4$,

$R^1$, un atome d'hydrogène, un groupe méthyle ou éthyle,

$R^2$, $R^3$, des restes alkyle identiques ou différents ayant 1 à 20 atomes de carbone, ou $R_2$ et $R_3$, ensemble, le reste d'un système hétérocyclique ayant 4 à 8 atomes du cycle,

$R^4$, un atome d'hydrogène ou un reste alkyle ayant 1 à 20 atomes de carbone,

n, un nombre de 1 à 20

4. Matériau de transfert stratifié selon l'une des revendications 1 à 2, caractérisé par le fait que le couche sensible à la lumière contient, comme composant de liant (a), un polymérisat vinylique contenant des groupes amino, qui est préparé par réaction d'un polymère vinylique contenant des groupes réactifs avec des composés de la formule générale (II) ou (III)

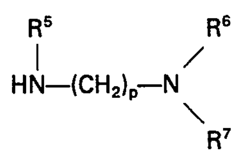 (II)

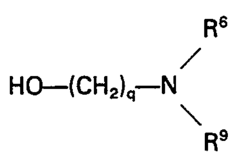 (III)

dans laquelle

$R^5$ représente un atome d'hydrogène ou un reste alkyle ayant 1 à 20 atomes de carbone

$R^6$, $R^7$, $R^8$, $R^9$ chacun des restes alkyle indentiques ou différentes ayant 1 à 20 atomes de carbone, les restes $R^6$ et $R^7$ ou $R^8$ et $R^9$ pouvant être reliés entre eux en formant un système hétérocyclique de 4 à 8 atomes de cycle

p, q représentent chacun un nombre de 1 à 20.

5. Matériau de transfert stratifié selon l'une des revendications 1 à 4, caractérisé par le fait que le polymérisat vinyliques contenant des grouyes amino contient incorporé additionnellement des groupes acide, en particulieur des groupes —COOH, en proportion de 0,1 à 5% en poids, rapportés à tout de liant (a).

6. Matériau de transfert stratifié selon l'une des revendications 1 à 5, caractérisé par le fait que la couche sensible à la lumière contient au moins un colorant.

7. Matériau de transfert stratifié selon l'une des revendications 1 à 5, caractérisé par le fait que la lumière contient un composé photochrome.

8. Procédé de préparation de photoréserves, sur des fonds métalliques au moyen d'un matériau de transfert stratifié comportant une couche sensible à la lumière appliquée sur un support de couche, temporaire, de dimension stable, ainsi qu'une feuille de dessus sur la couche sensible à la lumière, par détachement de la feuille de dessus de la couche sensible à la lumière, application par laminage de la couche sensible à la lumière sur le fond métallique, sous pression et eventuellement chaleur, exposition à la lumière, selon une image, de la couche sensible à la lumière, le support de couche temporaire étant détache de la couche sensible à la lumière, à volonté avant ou après l'exposition selon une image, et enfin lavage des zones non exposées de la couche sensible à la lumière, avec un solvant approprié, caractérisé par le fait que, dans ce procédé, on utilise un matériau de transfert stratifié selon l'une des revendications 1 à 7.

**Claims**

1. A dry film resist element for producing photoresist layers, comprising a temporary dimensionally stable base underneath a dry, light-sensitive layer which is solid at room temperature, and a cover sheet applied to the base remote surface of the light-sensitive layer, the adhesion of the cover sheet of the light-sensitive layer being less than the adhesion of the temporary base to the light-sensitive layer and the light-sensitive layer being formed of a photopolymerizable recording material suitable for producing photoresist layers and consisting essentially of such a mixture of

a) a thermoplastic vinyl polymer binder,

b) one or more photopolymerisable, ethylenically unsaturated, low molecular weight compounds compatible with binder a),

c) one of more photopolymerisable initiators, and optionally

d) other customary additives and/or auxiliaries,

is soluble or at least dispersible in an organic solvent, wherein binder a) is a vinyl polymer which contains from 0.05 to 3% by weight, based on the vinyl polymer, of incorporated polymer units having amino groups, these units having been introduced into the vinyl polymer by copolymerization with the corresponding monomers or by polymer-analogous reaction, which binder a) may in addition contain up to 5% by weight, based on binder a), of free carboxyl groups, with the proviso that these free carboxyl groups are formed by acrylic or methacrylic acid present as copolymerized units.

2. A dry film resist element as claimed in claim 1, wherein the amino-containing vinyl polymer is an acrylate or methacrylate polymer.

3. A dry film resist element as claimed in either of claims 1 and 2, wherein the light-sensitive layer contains as binder component a) a copolymer of vinyl monomers, in particular acrylates and/or methacrylates, with comonomers of formula (I)

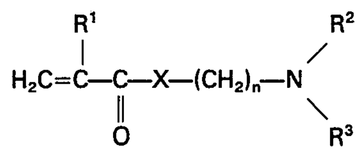

(I)

where

X is oxygen or $NR^4$,

$R^1$ is hydrogen, methyl or ethyl,

$R^2$ and $R^3$ are identical or different alkyl of 1 to 20 carbon atoms, or $R^4$ and $R^3$ together form the complement to a heterocyclic ring system of 4 to 8 ring atoms,

$R^4$ is hydrogen or alkyl or 1 to 20 carbon atoms, and

n is from 1 to 20.

4. A dry film resist element as claimed in either of claims 1 and 2, wherein the light-sensitive layer contains as binder a) an amino-containing vinyl polymer prepared by reacting a vinyl polymer which contains reactive groups with a compound of the general formula (II) or (III)

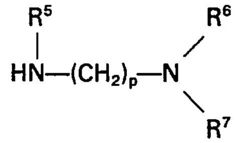

(II)

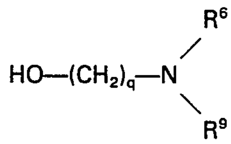

(III)

where

$R^5$ is hydrogen or an alkyl of 1 to 20 carbon atoms,

$R^6$, $R^7$, $R^8$ and $R^9$ are each identical or different alkyl of 1 to 20 carbon atoms or $R^6$ and $R^7$ on the one hand and $R^8$ and $R^9$ on the other may be bonded together to form a heterocyclic ring system of 4 to 89 ring atoms, and

p and q are each an integer from 1 to 20.

5. A dry film resist element according to any one of claims 1 to 4, wherein the amino-containing vinyl polymer additionally contains free acid groups, in particular —COOH groups, in an amount of from 0.1 to 5% by weight, based on total binder a), as incorporated units.

6. A dry film resist element according to any one of claims 1 to 5, wherein the light-sensitive layer contains one or more dyes.

7. A dry film resist element according to any one of claims 1 to 5, wherein the light-sensitive layer contains one or more photochromic compounds.

8. A process for producing a photoresist on a metallic substrate by means of a dry film resist element comprising a light-sensitive layer atop a dimensionally stable, temporary base and a cover sheet atop the light-sensitive layer, by peeling the cover sheet off the light-sensitive layer, laminating the light-sensitive layer onto the metallic substrate by pressing with or without heating, subjecting the light-sensitive layer to imagewise exposure, the temporary base being peeled off the light-sensitive layer facultatively either before or after imagewise exposure, and finally washing out the unexposed areas of the light-sensitive layer with a suitable solvent, which comprises using a dry film resist element as claimed in any one of claims 1 to 7.